(19) Europäisches Patentamt
European Patent Office
Office européen des brevets

(11) **EP 2 511 719 A1**

(12) **EUROPÄISCHE PATENTANMELDUNG**

(43) Veröffentlichungstag:
**17.10.2012 Patentblatt 2012/42**

(51) Int Cl.:
***G01R 31/02*** *(2006.01)*

(21) Anmeldenummer: **11162620.6**

(22) Anmeldetag: **15.04.2011**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**

(71) Anmelder: **SIEMENS AKTIENGESELLSCHAFT
80333 München (DE)**

(72) Erfinder:
• **Aufschneider, Klaus
92278 Illschwang (DE)**
• **Haller, Herbert
92260 Fichtenhof (DE)**
• **Kneidl, Andreas
92729 Weiherhammer (DE)**
• **Lee, Kyoung-Jin
92271 Freihung (DE)**

(54) **Verfahren zum Bestimmen einer Fehlfunktion eines Potentiometers**

(57) Die Erfindung betrifft Verfahren zum Bestimmen einer Fehlfunktion eines Potentiometers (10), wobei das Potentiometer mit zumindest einem zweiten elektrischen Widerstand (R861, R862) in Serie geschalten wird und eine Versorgungsspannung ($U_v$) an die so geschaffene Widerstandsanordnung angelegt wird. Es wird eine geeignete elektrischen Spannung ($U_{POTI-PIN1-IA/IB}$, $U_{POTI-PIN2-IA/IB}$) über einem oder mehreren Widerständen (R860, R861, R862) abgegriffen und mit zumindest einem weiteren Spannungswert ($U_{POTI-PIN1-IA/IB}$, $U_{POTI-PIN2-IA/IB}$, $U_{POTI-PIN3-IA/IB}$, $U_{PO-TI-PIN1-IA/IB-min}$, $U_{POTI-PIN1-IA/IB}$-max, $U_{2Links}$, $U_{2Rechts}$) verglichen.

**Beschreibung**

Die Erfindung betrifft ein Verfahren zum Bestimmen einer Fehlfunktion eines Potentiometers sowie eine Vorrichtung, welche gemäß einem der Verfahren arbeitet. Die Erfindung betrifft auch eine Steuereinheit mit einer solchen Vorrichtung.

Steuerungen und Schaltgeräte weisen häufig eine zeitverzögerte Reaktion auf. Diese kann beispielsweise im verzögerten Schalten eines Ausgangs bestehen. Entsprechend der derzeitigen Normenlage muss eine entsprechende Verzögerungszeit bestimmten sicherheitsrelevanten Anforderungen genügen. Insbesondere muss ein Fehler im Stellglied der Steuerung bzw. des Schaltgeräts, zum Beispiel ein Fehler an einem Potentiometer, erkannt und technisch beherrscht werden, damit es zu keinem gefährlichen Zustand einer Anlage mit der Steuerung bzw. dem Schaltgerät kommt.

Die an einem Schleifer des Potentiometers anliegende Spannung wird üblicherweise mittels eines A/D-(analog/digital) Wandlers eines Mikrocontrollers eingelesen und ausgewertet. Beim Auftreten eines Hardwarefehlers (z.B. Bauteildefekt des Potentiometers; Leitungsbruch; Schluss gegen eine Versorgungsspannung, so genannter P-Schluss; Schluss gegen Masse, so genannter M-Schluss; etc.) liegt am Eingang des A/D-Wandlers ein verfälschter Wert an, der jedoch von einem nachgeschalteten Controller nicht als solcher erkannt wird.

Deshalb sind Sicherheitsschaltgeräte und sichere Steuerungen bekannt, bei denen die Einstellung der Zeitverzögerung mittels zweier redundanter Potentiometer realisiert wird. Die von den beiden Potentiometern ausgegebenen Signale werden dabei von zwei verschiedenen Controllern redundant eingelesen und ausgewertet. Werden von den Controllern unterschiedliche Werte eingelesen, wird ein Fehler angenommen und das Sicherheitsschaltgerät bzw. die Steuereinheit geht in einen sicheren Zustand über.

Es ist Aufgabe der Erfindung, eine Fehlfunktion eines Potentiometers, welches insbesondere in einer Steuereinheit vorliegt, noch zuverlässiger und aufwandsärmer zu erkennen.

Diese Aufgabe wird durch Verfahren mit den Merkmalen der Patentansprüche 1, 2 und 3, einer Vorrichtung, welche die Merkmale des Patentanspruchs 7 aufweist, sowie eine Steuereinheit mit den Merkmalen des Patentanspruchs 8 gelöst.

Ein erstes erfindungsgemäßes Verfahren dient zum Bestimmen einer Fehlfunktion eines Potentiometers und umfasst die folgenden Schritte:

- In-Serie-Schalten des Potentiometers, welches durch einen elektrischen Gesamtwiderstand charakterisiert ist, mit zumindest einem zweiten elektrischen Widerstand und Anlegen einer Versorgungsspannung an die so geschaffene Widerstandsanordnung;
- Abgreifen einer elektrischen Spannung über dem zweiten Widerstand oder über einem der zweiten Widerstände;
- Festlegen einer minimalen Sollspannung für die Versorgungsspannung sowie für bauartbedingte erste extremale Widerstandswerte des Potentiometers und/oder des zumindest einen zweiten Widerstands;
- Festlegen einer maximalen Sollspannung für die Versorgungsspannung sowie für bauartbedingte zweite extremale Widerstandswerte des Potentiometers und/oder des zumindest einen zweiten Widerstands;
- Vergleichen des Werts der abgegriffenen elektrischen Spannung mit der minimalen und maximalen Sollspannung;
- für den Fall, dass der Wert der abgegriffenen Spannung innerhalb eines Werteintervalls liegt, dessen Grenzen durch die minimale und maximale Sollspannung definiert sind, Bereitstellen von Daten, welche einer einwandfreien Funktion des Potentiometers zugeordnet sind, und für den Fall, dass der Wert der abgegriffenen Spannung außerhalb des Werteintervalls liegt, Bereitstellen von Daten, welche einer Fehlfunktion des Potentiometers zugeordnet sind.

Die Widerstände in der Widerstandsanordnung können insbesondere einen individuellen Nominalwiderstandswert aufweisen, von dem bei jedem Widerstandsbauteil innerhalb bestimmter Toleranzgrenzen abgewichen werden kann. Weist das Potentiometer und/oder der zumindest eine zweite Widerstand einen Nominalwiderstandswert von R mit der Toleranz +/- x% auf, so kann ein bauartbedingter erster extremaler Widerstandswert durch den minimalen Widerstandswert $R-0,01*x*R$ gegeben sein. Dann kann ein bauartbedingter zweiter extremaler Widerstandswert durch den Wert $R+0,01*x*R$ gegeben sein. Im Falle einer vorgegebenen Versorgungsspannung wird die abgegriffene elektrische Spannung insbesondere von den Werten der Widerstände innerhalb der Widerstandsanordnung und damit auch von den bauartbedingten Toleranzen der zugehörigen Widerstandswerte abhängen. Für die Berechnung einer minimalen Sollspannung können dann die Widerstandswerte mit ihren Toleranzabweichungen so in eine zugeordnete Berechnungsformel eingehen, dass sich ein globales Minimum einstellt. Analog kann für die maximale Sollspannung vorgegangen werden. Dann sind insbesondere Intervallgrenzen für die Spannung vorgegeben, innerhalb derer die abgegriffene elektrische Spannung auch unter Berücksichtigung aller möglicher Widerstandstoleranzen auf jeden Fall liegen muss. Dem Verfahren liegt die Erkenntnis zugrunde, dass für den Fall, dass der Wert der abgegriffenen elektrischen Spannung außerhalb eines so festgelegten und durch Extremalwerte begrenzten Werteintervalls liegt, ein Fehler und insbesondere eine Fehlfunktion am Potentiometer vorliegen muss. Insbesondere wird ein Fehler angenommen, wenn der gemessene Spannungswert inkonsistent zu einer Annahme ist, welche auch unter Berücksichtigung ungünstiger bauartbedingter Schwankungen getroffen ist.

Durch eine einfach durchzuführende Spannungsmessung an dem zweiten elektrischen Widerstand kann eine Aussage darüber getroffen werden, ob das Potentiometer funktionstüchtig ist oder nicht. Die Notwendigkeit, Signale, welche von zwei unabhängigen Potentiometern bereitgestellt werden, auszuwerten, entfällt. Es kann einfach und dennoch zuverlässig auf einen Fehler geschlossen werden.

Ein zweites erfindungsgemäßes Verfahren dient ebenfalls zum Bestimmen einer Fehlfunktion eines Potentiometers und umfasst die folgenden Schritte:

- In-Serie-Schalten des Potentiometers, welches durch einen elektrischen Gesamtwiderstand charakterisiert ist, mit zumindest einem zweiten elektrischen Widerstand und Anlegen einer Versorgungsspannung an die so geschaffene Widerstandsanordnung;
- Abgreifen einer elektrischen Spannung über dem zweiten Widerstand oder einem der zweiten Widerstände und einem einstellbaren Teilwiderstand des Gesamtwiderstands des Potentiometers gemeinsam, wobei ein minimaler einstellbarer Teilwiderstand größer als der Wert Null ist und ein maximaler einstellbarer Teilwiderstand kleiner als der Gesamtwiderstand ist;
- Festlegen einer minimalen Sollspannung für die Versorgungsspannung sowie für bauartbedingte und/oder einstellbare erste extremale Widerstandswerte des Potentiometers und/oder des zumindest einen zweiten Widerstands;
- Festlegen einer maximalen Sollspannung für die Versorgungsspannung sowie für bauartbedingte und/oder einstellbare zweite extremale Widerstandswerte des Potentiometers und/oder des zumindest einen zweiten Widerstands;
- Vergleichen des Werts der abgegriffenen elektrischen Spannung mit der minimalen und maximalen Sollspannung;
- für den Fall, dass der Wert der abgegriffenen Spannung kleiner als die minimale Sollspannung oder größer als die maximale Sollspannung ist, Bereitstellen von Daten, welche einer Fehlfunktion des Potentiometers zugeordnet sind, ansonsten Bereitstellen von Daten, welche einer einwandfreien Funktion des Potentiometers zugeordnet sind.

Wie gemäß dem ersten erfindungsgemäßen Verfahren werden auch im zweiten erfindungsgemäßen Verfahren das Potentiometer und der zweite bzw. die zweiten elektrischen Widerstände in Serie bzw. in Reihe geschalten. Nunmehr wird jedoch die Spannung am einstellbaren Teilwiderstand des Potentiometers und am zweiten Widerstand gemeinsam abgegriffen. Das heißt, wenn der zweite Widerstand den Widerstandswert R1 besitzt und der Teilwiderstand den Widerstandswert R2 besitzt, dass die Spannung über R1 und R2 gemeinsam abgegriffen wird, also über R1+R2. Die minimale und maximale Sollspannung werden wiederum über die Versorgungsspannung als auch über die variablen Widerstandswerte der in der Widerstandsanordnung vorliegenden Widerstände festgelegt. Ein solcher variabler Widerstandswert kann entweder bauartbedingt sein, das heißt ein Widerstand mit einem nominalen Widerstandswert kann tatsächliche Widerstandswerte in einem Toleranzband um diesen Nominalwert herum aufweisen. Es kann aber auch sein, dass die Variabilität des Widerstands durch die Einstellbarkeit des Teilwiderstands des Potentiometers bedingt ist. Die minimale und maximale Sollspannung kann nun durch einen oder mehrere bauartbedingte Widerstandswerte alleine, oder einen extremal einstellbaren Widerstandswert des Potentiometers alleine, oder bauartbedingte Widerstandswerte und den einstellbaren extremalen Widerstandswert gemeinsam festgelegt werden.

Auf diese Art wird der Einstellbarkeit des Potentiometerwiderstands besondere Rechnung getragen. Erst dann, wenn ein Messwert von einem auf Grund der Einstellgrenzen der Potentiometer zu erwartenden Messwert abweicht, kann von einer Fehlfunktion des Potentiometers ausgegangen werden. Das Potentiometer wird deshalb insbesondere so ausgestaltet, dass der Teilwiderstand nicht vollständig in den Grenzen des Gesamtwiderstands des Potentiometers variabel einstellbar ist; insbesondere Randbereiche sehr kleiner bzw. sehr großer Teilwiderstände nicht einstellbar sind. Das Verfahren erlaubt insbesondere Rückschlüsse auf eine mögliche Unterbrechung eines Schleifers des Potentiometers bzw. auf einen Masseschluss (M-Schluss) am Schleifer des Potentiometers. Auch ein Schluss gegen die Versorgungsspannung, ein so genannter P-Schluss, kann sehr gut identifiziert werden. Damit ist nicht nur eine Aussage möglich, ob ein Fehler am Potentiometer vorliegt, sondern auch die Art des Fehlers kann identifiziert werden.

Auch ein drittes erfindungsgemäßes Verfahren dient zum Bestimmen einer Fehlfunktion eines Potentiometers und umfasst die folgenden Schritte:

- In-Serie-Schalten des Potentiometers, welches durch einen elektrischen Gesamtwiderstand charakterisiert ist, mit zumindest einem zweiten elektrischen Widerstand und Anlegen einer Versorgungsspannung an die so geschaffene Widerstandsanordnung;
- Abgreifen einer elektrischen Spannung über dem zweiten Widerstand oder einem der zweiten Widerstände und einem einstellbaren Teilwiderstand des Gesamtwiderstands des Potentiometers gemeinsam, wobei ein minimaler einstellbarer Teilwiderstand größer als der Wert Null ist und ein maximaler einstellbarer Teilwiderstand kleiner als der Gesamtwiderstand ist;
- Abgreifen einer elektrischen Vergleichsspannung über dem zweiten Widerstand oder einem der zweiten Widerstände und dem Gesamtwiderstand des Potentiometers gemeinsam, oder Abgreifen der elektrischen Vergleichsspannung über dem zweiten Widerstand oder einem der zweiten Widerstände alleine;

- Vergleichen des Werts der abgegriffenen elektrischen Spannung mit der Vergleichsspannung;
- für den Fall, dass der Wert der abgegriffenen Spannung innerhalb eines vorgegebenen Toleranzbereichs mit dem Wert der Vergleichsspannung übereinstimmt, Bereitstellen von Daten, welche einer Fehlfunktion des Potentiometers zugeordnet sind, ansonsten Bereitstellen von Daten, welche einer einwandfreien Funktion des Potentiometers zugeordnet sind.

Wie im zweiten erfindungsgemäßen Verfahren erfolgt auch im Rahmen des dritten erfindungsgemäßen Verfahrens ein Abgreifen der elektrischen Spannung über dem Widerstand und dem einstellbaren Teilwiderstand zusammen. Es ist nunmehr insbesondere zusätzlich vorgesehen, eine weitere elektrische Vergleichsspannung abzugreifen und einen Vergleich beider gemessener Spannungen durchzuführen. Das Abgreifen der elektrischen Vergleichsspannung erfolgt insbesondere nicht über einem Teilwiderstand des Gesamtwiderstands des Potentiometers, sondern entweder unter Berücksichtigung des Gesamtwiderstands des Potentiometers oder aber ohne Berücksichtigung desselben. Das Verfahren macht sich die Erkenntnis zu Nutze, dass zwei, über verschiedenen Widerständen gemessene Spannungswerte nicht übereinstimmen können. Es ist insbesondere kein Vergleich mit einem abgelegten bzw. abgespeicherten Spannungswert erforderlich. Gegebenenfalls reicht ein Vergleich hinsichtlich der Frage, ob die beiden Spannungswerte übereinstimmen, aus, ohne dass die Absolutbeträge von Spannung und Vergleichsspannung bekannt sein müssen. Diese Art des Vergleichs leichtert die Messung erheblich und erlaubt dennoch eine eindeutige Identifikation einer Fehlfunktion des Potentiometers. Ein Kurzschluss eines Schleifers des Potentiometers gegenüber einer weiteren Anschlussseite des Potentiometers innerhalb der Widerstandsanordnung lässt sich eindeutig identifizieren.

Den erfindungsgemäßen Verfahren liegt die übergeordnete Erkenntnis zu Grunde, dass für die Bestimmung einer Fehlfunktion eines Potentiometers ein Vergleich mit Messwerten, welche an einem baugleichen zweiten Potentiometer redundant gewonnen werden, nicht erforderlich ist. Es reicht aus, geeignete Spannungen in einer Widerstandsanordnung, welche das zu untersuchende Potentiometer umfasst, abzugreifen und geeignete Konsistenzbetrachtungen anzustellen. Für solche Konsistenzbetrachtungen können die Fehlertoleranzen der einzelnen Widerstände innerhalb der Widerstandsanordnung, die Einstellgrenzen des Potentiometers oder aber der Vergleich verschiedener Spannungsabgriffe innerhalb der Widerstandsanordnung herangezogen werden. Es ist eine vergleichsweise einfache und dennoch sehr zuverlässige Methode geschaffen, Fehlfunktionen eines Potentiometers zu erkennen. Je nach Ausgestaltung des Verfahrens ist hierbei insbesondere nicht nur ein Erkennen im Sinne von "Fehler" oder "kein Fehler" möglich, sondern es kann auch auf die Art des Fehlers rückgeschlossen werden. Es lassen sich nahezu alle anzunehmenden Fehler in der Schaltung aufdecken. Die sicherheitskritischen Hardwarefehler P-Schluss, M-Schluss, Leitungsunterbrechung und Bauteildefekt lassen sich zuverlässig aufdecken. Hierfür ist insgesamt nur ein Potentiometer erforderlich.

Vorzugsweise wird die abgegriffene elektrische Spannung in zumindest zwei Auswerteeinheiten unabhängig voneinander ausgewertet. Dann kann insbesondere vorgesehen sein, dass auf eine Fehlfunktion geschlossen wird, wenn die in den Auswerteeinheiten erkannten elektrischen Spannungswerte zumindest innerhalb bestimmter Intervalle nicht miteinander übereinstimmen. Durch Redundanz wird auf diese Art die Zuverlässigkeit des Fehlererkennungsverfahrens verbessert. Durch zwei unabhängige Messvorrichtungen wird die Qualität der gemessenen Spannungswerte erhöht und es steht eine Möglichkeit zur Validierung bereit.

Vorzugsweise umfassen die Verfahren die folgenden zusätzlichen Schritte:

- Detektieren der abgegriffenen elektrischen Spannung in einer ersten der zumindest zwei Auswerteeinheiten über einen ersten Vorwiderstand;
- Bestimmen eines Werts der abgegriffenen elektrischen Spannung in der ersten Auswerteeinheit;
- Detektieren der abgegriffenen elektrischen Spannung in einer zweiten der zumindest zwei Auswerteeinheiten über einen zweiten Vorwiderstand;
- Bestimmen eines Werts der abgegriffenen elektrischen Spannung in der zweiten Auswerteeinheit; und
- falls die in der ersten und zweiten Auswerteeinheit bestimmten Werte der abgegriffenen elektrischen Spannung innerhalb vorgegebener Toleranzgrenzen nicht übereinstimmen, Bereitstellen von Daten, welcher eine Fehlfunktion des Potentiometers zugeordnet sind.

Diese Ausführungsform erlaubt Rückschlüsse darüber, ob ein Eingang einer der Auswerteeinheiten "offen" ist, also eine Unterbrechung des zugehörigen Vorwiderstands vorliegt. In diesem Fall würde ein undefinierter Spannungswert in die Auswerteeinheit eingelesen und sicherer Aussagen über die Funktionsfähigkeit des Potentiometers wären nicht mehr möglich. Deshalb wird vorsichtshalber auf eine Fehlfunktion des Potentiometers geschlossen, da zumindest eine Fehlfunktion der Schaltungsanordnung vorliegt. Auf diese Weise werden unerwünschte und gegebenenfalls gefährliche Zustände der Schaltungsanordnung vermieden.

Vorzugsweise ist an dem Potentiometer ein Teilwiderstand in den Grenzen 2% bis 98% des Gesamtwiderstands des Potentiometers einstellbar, wobei diese Grenzen mechanisch durch eine Schleiferstellung begrenzt werden. Kurzschlüsse am Potentiometer lassen sich auf diese Weise einfacher identifizieren. Dennoch ist der Teilwiderstand über große Bereiche hinweg einstellbar.

Eine erfindungsgemäße Vorrichtung dient zur Bestimmung einer Fehlfunktion eines Potentiometers und arbeitet nach einem oder einer Kombination der erfindungsgemäßen Verfahren.

Eine erfindungsgemäße Steuereinheit umfasst eine erfindungsgemäße Vorrichtung und ist dazu ausgebildet, in einen festgelegten Betriebszustand überzugehen, wenn von der Vorrichtung Daten bereitgestellt werden, welcher einer Fehlfunktion des Potentiometer zugeordnet sind. Dann ist eine sichere Steuereinheit bzw. ein Sicherheitsschaltgerät geschaffen, durch welches insbesondere sicherheitsbezogene Normvorgaben erfüllt sind. Bei dem festgelegten Betriebszustand kann es sich insbesondere um eine abgeschalteten Zustand bzw. Ruhezustand der Steuereinheit handeln. Im Falle eines erkannten Fehlers am Potentiometer kann so insbesondere eine Notabschaltung stattfinden.

Die mit Bezug auf die erfindungsgemäßen Verfahren dargestellten bevorzugten Ausführungsformen und deren Vorteile gelten entsprechend für die erfindungsgemäße Vorrichtung sowie die erfindungsgemäße Steuereinheit.

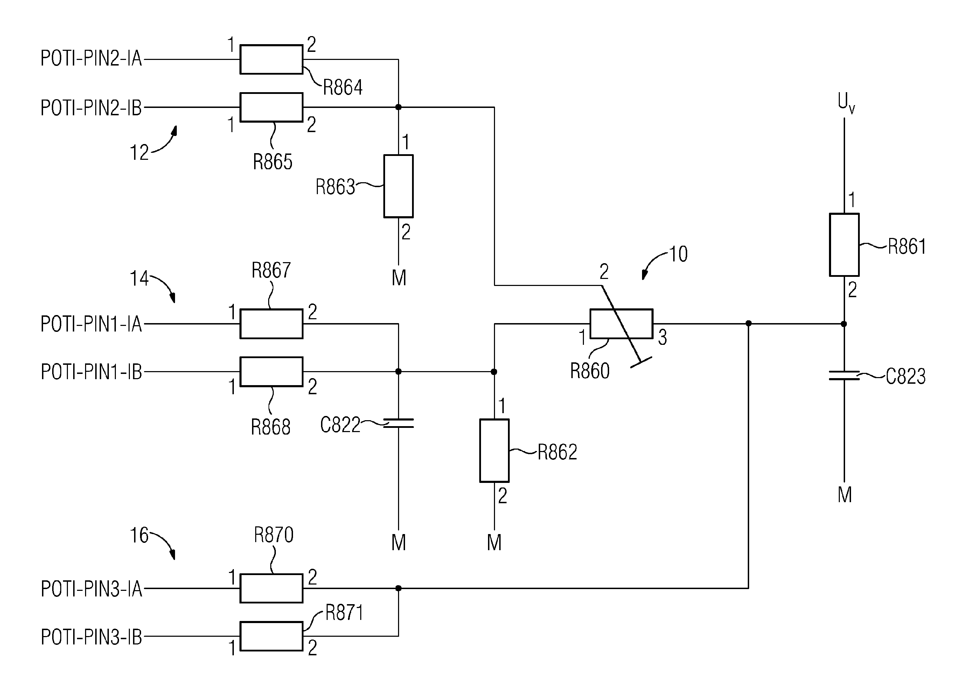

Anhand eines Ausführungsbeispiels wird die Erfindung im Folgenden näher erläutert. Die Figur zeigt eine Schaltungsanordnung, mit Hilfe der sich eine Fehlfunktion eines Potentiometers bestimmen lässt.

Ein Potentiometer 10 mit dem Gesamtwiderstand R860 befindet sich in Reihenschaltung mit den festen, nicht einstellbaren Widerständen R861 und R862. Das Potentiometer 10 verfügt über drei Anschlüsse bzw. Pins 1, 2 und 3. Der Pin 2 ist an einem Schleifer des Potentiometers 10 ausgebildet. Zusätzlich sind in der Schaltung ein Widerstand R863 sowie Kondensatoren bzw. Kapazitäten C822 und C823 vorgesehen. Eine Versorgungsspannung $U_v$ liegt gegenüber den Anschlüssen M an.

Es sind insgesamt sechs Messanschlüsse mit vorgeschalteten Vorwiderständen vorgesehen: Anschluss POTI-PIN1-IA mit Vorwiderstand R867, Anschluss POTI-PIN1-IB mit Vorwiderstand R868, Anschluss POTI-PIN2-IA mit Vorwiderstand R864, Anschluss PO-TI-PIN2-IB mit Vorwiderstand R865, Anschluss POTI-PIN3-IA mit Vorwiderstand R870 und Anschluss POTI-PIN3-IB mit Vorwiderstand R871. Die Angaben "PIN1", "PIN2" und "PIN3" beziehen sich hierbei auf die Pins 1, 2 bzw. 3 am Potentiometer 10. Die mit "IA" gekennzeichneten Anschlüsse führen hierbei jeweils zu einem ersten Controller, während die mit "IB" endenden Anschlüsse jeweils zu einem vom ersten Controller unabhängigen zweiten Controller führen. Auf diese Art ist durch die Anschlüsse POTI-PIN1-IA und POTI-PIN1-IB eine erste Messanordnung 12, durch die Anschlüsse POTI-PIN2-IA und POTI-PIN2-IB eine zweite Messanordnung 14 und durch die Anschlüsse POTI-PIN3-IA und POTI-PIN3-IB eine dritte Messanordnung 16 geschaffen. Die jeweils zugehörigen Messspannungen seien mit $U_{POTI-PIN1-IA/IB}$, $U_{POTI-PIN2-IA/IB}$ und $U_{POTI-PIN3-IA/IB}$ bezeichnet.

Nun besteht die Idee darin, durch diesen Hardwareaufbau mit abgestimmten Widerstandswerten als Spannungsteiler und der Festlegung von Toleranzbändern für die zulässigen Messwerte an den Messanordnungen 12, 14 und 16 eine große Zahl möglicher Fehler in der Schaltungsanordnung aufzudecken. Die zu den Messanordnungen 12, 14 und 16 gehörenden Controllern sind hierbei mit einem AD-Wandler ausgestattet und umfassen einen Mikrocontroller. Die Auflösung des AD-Wandlers des Mikrocontrollers, welche im Ausführungsbeispiel 10 Bit beträgt, kann bei der Dimensionierung des Spannungsteilers und der Festlegung der Toleranzbänder berücksichtigt werden.

Der Potentiometergesamtwiderstand (zwischen Pin 1 und Pin 3 von R860) wird über die AD-Wandlereingänge POTI-PIN1-IA und POTI-PIN1-IB zweikanalig eingelesen und überprüft. Grundsätzlich gibt es keine Beschränkungen auf spezielle Widerstandswerte und Toleranzen des Potentiometers; jedoch sollte zum Beispiel die maximal zulässige Verlustleistung berücksichtigt werden. Im Ausführungsbeispiel wurde ein handelsübliches Potentiometer mit $R860 = 10k\Omega \pm 10\%$ eingesetzt. Die gemessene Spannung $U_{POTI-PIN1-IA/IB}$ an den Eingängen POTI-PIN1-IA und POTI-PIN1-IB (Gesamtwiderstandsmessung) muss rechnerisch zwischen einer Mindestspannung $U_{POTI-PIN1-IA/IB-min}$ und einer Maximalspannung $U_{POTI-PIN1-IA/IB-max}$ liegen. Diese Spannungswerte errechnen sich nach der Formel

$$U_{POTI-PIN1-IA/IB} = U_V \cdot \frac{R862}{R860 + R861 + R862}$$

unter Berücksichtigung der Bauteiltoleranzen der Widerstände R860, R861 und R862. Im Ausführungsbeispiel betragen diese Widerstandswerte:

$$R860 = 10\,k\Omega \pm 10\% ;$$

$$R861 = 220\,\Omega \pm 1\% \; ;$$

$$R862 = 220\,\Omega \pm 1\% \; .$$

Mit einer Versorgungsspannung $U_v$=5V ergibt sich damit $U_{POTI\text{-}PINI\text{-}IA/IB\text{-}min}$ = 94mV und $U_{POTI\text{-}PIN1\text{-}IA/IB\text{-}max}$ =118mV. Eine Fehleraufdeckung ist dann wie folgt möglich:

I. Überprüfung der Potentiometeranbindung an Pin 1 bzw. Pin 3 auf Unterbrechung: Ein Spannungswert, für den gilt $U_{POTI\text{-}PIN1\text{-}IA/IB} < U_{POTI\text{-}PIN1\text{-}IA/IB\text{-}min}$ ist rechnerisch nicht möglich und kann als Ursache nur eine Unterbrechung der Potentiometeranbindung an Pin 1 bzw. Pin 3 haben.

II. Überprüfung der Potentiometeranbindung an Pin 1 bzw. Pin 3 auf Kurzschluss: Ein Spannungswert, für den gilt $U_{POTI\text{-}PIN1\text{-}IA/IB} > U_{POTI\text{-}PIN1\text{-}IA/IB\text{-}max}$ ist rechnerisch nicht möglich und kann als Ursache nur einen Kurzschluss der Potentiometeranbindung an Pin 1 bzw. Pin 3 haben.

Alternativ oder zusätzlich können auch Messwerte der Messanordnung 12 herangezogen werden. Hierbei wird die Stellung des Potentiometers 10 über die Eingänge bzw. Anschlüsse POTI-PIN2-IA und POTI-PIN2-IB redundant erfasst. Der Schleifer des Potentiometers (Pin 2 des Widerstands R860) kann rechnerisch zwischen R861 (220 Ohm) und R860+10%+R861 (11,22 Kilo-Ohm) abgreifen. Für die gemessene Spannung an diesen Eingängen gilt allgemein:

$$U_{POTI-PIN2-IA/IB} = U_V \cdot \frac{X \cdot R860 + R862}{R860 + R861 + R862}$$

Im linken Anschlag des Potentiometers gilt damit für die Spannung:

$$U_{2Links} = U_V \cdot \frac{X_{min} \cdot R860 + R862}{R860 + R861 + R862} = 194mV...218mV$$

Im rechten Anschlag des Potentiometers gilt damit für die Spannung:

$$U_{2Rechts} = U_V \cdot \frac{X_{max} \cdot R860 + R862}{R860 + R861 + R862} = 4,77V...4,80V$$

$X_{min}$ und $X_{max}$ sind hierbei Faktoren, welche die Schleiferstellung (Pin 2) von Potentiometer 10 charakterisieren. Im Ausführungsbeispiel ist $X_{min}$=0, 02 (das heißt, dass ein minimal einstellbarer Potentiometerwiderstand 2% des Gesamtwiderstand R860 beträgt). Entsprechend beträgt $X_{max}$=0,98. Die angegebenen Intervalle für die Zahlwerte der Vergleichsspannungen $U_{2Links}$ und $U_{2Rechts}$ ergeben sich wiederum durch die Bauteiltoleranzen der in die Formel eingehenden Widerstände (

$$\pm 10\%$$

für R860 bzw.

$$+\!\!\!/_-\,1\%$$

für R861 und R862).

Es ist dann folgende Fehleraufdeckung möglich:

III. Überprüfung des Schleifers auf Unterbrechung und auf Masseschluss (M-Schluss): Wird an den Eingängen POTI-PIN2-IA bzw. POTI-PIN2-IB ein Spannungswert kleiner $U_{POTI-PIN2-IA/IB-Links}$ gemessen, ist der Schleifer (Pin 2 von R860) unterbrochen oder es liegt ein Massenschluss am Pin 2 vor.

IV. Überprüfung des Schleifers auf Schluss gegen die Versorgungsspannung (P-Schluss): Wird an den Eingängen PO-TI-PIN2-IA bzw. POTI-PIN2-IB eine Spannung gemessen, welche größer als $U_{POTI-PIN2-IA/IB-Rechts}$ ist, liegt ein P-Schluss am Schleifer vor.

Über die Anschlüsse POTI-PIN3-IA und POTI-PIN3-IB wird die Folgende Spannung über den Widerständen R860 und R862 gemeinsam gemessen:

$$U_{POTI-PIN3-IA/IB} = U_V \cdot \frac{R860 + R862}{R860 + R861 + R862}$$

Es sind folgende weitere Fehlerüberprüfungen möglich:

V. Überprüfung des Schleifers (Pin 2) auf Schluss gegen Pin 1 des Potentiometers 10: Durch eine mechanische Begrenzung des Potentiometerdrehwinkels auf $X_{min} \cdot R860$ wird ausgeschlossen, dass die gemessenen Spannungen $U_{POTI-PIN1-IA/IB}$ und $U_{POTI-PIN2-IA/IB}$ identisch sind. Wird dennoch durch einen der Controller festgestellt, dass gilt:

$U_{POTI-PIN1-IA/IB} = U_{POTI-PIN2-IA/IB}$ so kann auch auf einen Kurzschluss des Schleifers gegen Pin 1 rückgeschlossen werden. Dieser unzulässige Zustand wird als Fehler erkannt.

VI. Überprüfung des Schleifers (Pin 2) auf Schluss gegen Pin 3 des Potentiometers 10. Durch eine mechanische Begrenzung des Potentiometerdrehwinkels auf $X_{max} \cdot R860$ wird ausgeschlossen, dass die gemessenen Spannungen $U_{POTI-PIN3-IA/IB}$ und $U_{POTI-PIN2-IA/IB}$ identisch sind. Wird dennoch durch einen der Controller festgestellt, dass gilt:

$U_{POTI-PIN3-IA/IB} = U_{POTI-PIN2-IA/IB}$, so kann auf einen Kurzschluss des Schleifers gegen Pin 3 geschlossen werden. Dieser unzulässige Zustand wird als Fehler erkannt.

Ein weiterer Fehler kann in der Unterbrechung von Vorwiderständen bestehen und ebenfalls in der Messanordnung erkannt werden. Folgende Fehler können aufgedeckt werden:

VII. Unterbrechung der Vorwiderstände R864 und R865: Die Spannung am Schleifer des Potentiometers 10 wird redundant von den Controllern A und B eingelesen. Ist ein Eingang "offen" (das heißt Unterbrechung des Vorwiderstands), wird hier ein undefinierter Wert eingelesen. Da am redundanten Eingang der "richtige" Wert anliegt, lesen beide Controller unterschiedliche Werte ein und ein Fehler wird erkannt.

VIII. Unterbrechung der Vorwiderstände R867 und R868: Die Spannung am Potentiometergesamtwiderstand wird redundant von den Controllern A und B eingelesen. Ist ein Eingang "offen" (das heißt Unterbrechung des Vorwiderstands), wird hier ein undefinierter Wert eingelesen. Da am redundanten Eingang der "richtige" Wert anliegt, lesen beide Controller unterschiedliche Werte ein und ein Fehler wird erkannt.

Die Auswertung der Potentiometerstellung sowie die daraus abgeleiteten Größen sind sicher. Alle für die Potentiometerauswertung sicherheitskritischen Hardwarefehler werden aufgedeckt (P-Schluss, M-Schluss, Leitungsunterbrechung, Bauteildefekt). Zudem genügt für eine sichere Potentiometerauswertung ausschließlich ein einziges Potentiometer 10, welches von zwei Controllern ausgewertet wird. Alternativ ist jedoch auch eine Auswertung mit nur einem Controller als Auswerteeinheit möglich.


**Patentansprüche**

1. Verfahren zum Bestimmen einer Fehlfunktion eines Potentiometers (10) mit den Schritten:

   - In-Serie-Schalten des Potentiometers (10), welches durch einen elektrischen Gesamtwiderstand (R860) charakterisiert ist, mit zumindest einem zweiten elektrischen Widerstand (R861, R862) und Anlegen einer Versorgungsspannung ($U_v$) an die so geschaffene Widerstandsanordnung;
   - Abgreifen einer elektrischen Spannung ($U_{POTI-PIN1-IA/IB}$) über dem zweiten Widerstand (R862) oder über einem (R862) der zweiten Widerstände (R861, R862);
   - Festlegen einer minimalen Sollspannung ($U_{POTI-PIN1-IA/IB-min}$) für die Versorgungsspannung ($U_v$) sowie für bauartbedingte erste extremale Widerstandswerte des Potentiometers (10) und/oder des zumindest einen zweiten Widerstands (R861, R862);
   - Festlegen einer maximalen Sollspannung ($U_{POTI-PIN1-IA/IB-max}$) für die Versorgungsspannung ($U_v$) sowie für bauartbedingte zweite extremale Widerstandswerte des Potentiometers (10) und/oder des zumindest einen zweiten Widerstands (R861, R862);
   - Vergleichen des Werts der abgegriffenen elektrischen Spannung ($U_{POTI-PIN1-IA/IB}$) mit der minimalen ($U_{POTI-PIN1-IA/IB-min}$) und maximalen Sollspannung ($U_{POTI-PIN1-IA/IB-max}$);
   - für den Fall, dass der Wert der abgegriffenen Spannung ($U_{POTI-PIN1-IA/IB}$) innerhalb eines Werteintervalls liegt, dessen Grenzen durch die minimale ($U_{POTI-PIN1-IA/IB-min}$) und maximale Sollspannung ($U_{POTI-PIN1-IA/IB-max}$) definiert sind, Bereitstellen von Daten, welche einer einwandfreien Funktion des Potentiometers (10) zugeordnet sind, und für den Fall, dass der Wert der abgegriffenen Spannung ($U_{POTI-PIN1-IA/IB}$) außerhalb des Werteintervalls liegt, Bereitstellen von Daten, welche einer Fehlfunktion des Potentiometers (10) zugeordnet sind.

2. Verfahren zum Bestimmen einer Fehlfunktion eines Potentiometers (10) mit den Schritten:

   - In-Serie-Schalten des Potentiometers (10), welches durch einen elektrischen Gesamtwiderstand (R860) charakterisiert ist, mit zumindest einem zweiten elektrischen Widerstand (R861, R862) und Anlegen einer Versorgungsspannung ($U_v$) an die so geschaffene Widerstandsanordnung;
   - Abgreifen einer elektrischen Spannung ($U_{POTI-PIN2-IA/IB}$) über dem zweiten Widerstand (R862) oder einem (R862) der zweiten Widerstände (R861, R862) und einem einstellbaren Teilwiderstand ($X \times R860$) des Gesamtwiderstands (R860) des Potentiometers (10) gemeinsam, wobei ein minimaler einstellbarer Teilwiderstand ($X_{min} \times R860$) größer als der Wert Null ist und ein maximaler einstellbarer Teilwiderstand ($X_{max} \times R860$) kleiner als der Gesamtwiderstand (R860) ist;
   - Festlegen einer minimalen Sollspannung ($U_{2Links}$) für die Versorgungsspannung ($U_v$) sowie für bauartbedingte und/oder einstellbare erste extremale Widerstandswerte ($X_{min} \times R860$) des Potentiometers (10) und/oder des zumindest einen (R862) zweiten Widerstands (R861, R862);
   - Festlegen einer maximalen Sollspannung ($U_{2Rechts}$) für die Versorgungsspannung ($U_v$) sowie für bauartbedingte und/oder einstellbare zweite extremale Widerstandswerte ($X_{max} \times R860$) des Potentiometers (10) und/oder des zumindest einen (R862) zweiten Widerstands (R861, R862);
   - Vergleichen des Werts der abgegriffenen elektrischen Spannung ($U_{POTI-PIN2-IA/IB}$) mit der minimalen ($U_{2Links}$) und maximalen Sollspannung ($U_{2Rechts}$);
   - für den Fall, dass der Wert der abgegriffenen Spannung ($U_{POTI-PIN2-IA/IB}$) kleiner als die minimale Sollspannung ($U_{2Links}$) oder größer als die maximale Sollspannung ($U_{2Rechts}$) ist, Bereitstellen von Daten, welche einer Fehlfunktion des Potentiometers (10) zugeordnet sind, ansonsten Bereitstellen von Daten, welche einer einwandfreien Funktion des Potentiometers (10) zugeordnet sind.

3. Verfahren zum Bestimmen einer Fehlfunktion eines Potentiometers (10) mit den Schritten:

   - In-Serie-Schalten des Potentiometers (10), welches durch einen elektrischen Gesamtwiderstand (R860) charakterisiert ist, mit zumindest einem zweiten elektrischen Widerstand (R861, R862) und Anlegen einer Versorgungsspannung ($U_v$) an die so geschaffene Widerstandsanordnung;
   - Abgreifen einer elektrischen Spannung ($U_{POTI-PIN2-IA/IB}$) über dem zweiten Widerstand (R862) oder einem (R862) der zweiten Widerstände (R861, R862) und einem einstellbaren Teilwiderstand ($X \times R860$) des Gesamtwiderstands (R860) des Potentiometers (10) gemeinsam, wobei ein minimaler einstellbarer Teilwiderstand ($X_{min} \times R860$) größer als der Wert Null ist und ein maximaler einstellbarer Teilwiderstand ($X_{max} \times R860$) kleiner

als der Gesamtwiderstand (R860) ist;

- Abgreifen einer elektrischen Vergleichsspannung ($U_{POTI\text{-}PIN3\text{-}IA/IB}$) über dem zweiten Widerstand (R862) oder einem (R862) der zweiten Widerstände (R861, R862) und dem Gesamtwiderstand (R860) des Potentiometers (10) gemeinsam, oder Abgreifen der elektrischen Vergleichsspannung ($U_{POTI\text{-}PIN1\text{-}IA/IB}$) über dem zweiten Widerstand (R862) oder einem (R862) der zweiten Widerstände (R861, R862) alleine;

- Vergleichen des Werts der abgegriffenen elektrischen Spannung ($U_{POTI\text{-}PIN2\text{-}IA/IB}$) mit der Vergleichsspannung ($U_{POTI\text{-}PIN1}\text{-}IA/IB$, $U_{POTI\text{-}PIN3}\text{-}IA/IB$) ;

- für den Fall, dass der Wert der abgegriffenen Spannung ($U_{POTI\text{-}PIN2\text{-}IA/IB}$) innerhalb eines vorgegebenen Toleranzbereichs mit dem Wert der Vergleichsspannung ($U_{POTI\text{-}PIN1\text{-}IA/IB}$, $U_{POTI\text{-}PIN3\text{-}IA/IB}$) übereinstimmt, Bereitstellen von Daten, welche einer Fehlfunktion des Potentiometers (10) zugeordnet sind, ansonsten Bereitstellen von Daten, welche einer einwandfreien Funktion des Potentiometers (10) zugeordnet sind.

**4.** Verfahren nach einem der vorhergehenden Ansprüche,
**dadurch gekennzeichnet, dass**
die abgegriffene elektrische Spannung ($U_{POTI\text{-}PIN1\text{-}IA/IB}$, $U_{POTI\text{-}PIN2\text{-}IA/IB}$) in zumindest zwei Auswerteeinheiten (POTI-PIN1-IA, PO-TI-PIN1-IB; POTI-PIN2-IA, POTI-PIN2-IB; POTI-PIN3-IA, POTI-PIN3-IB) unabhängig voneinander ausgewertet wird.

**5.** Verfahren nach Anspruch 4,
**gekennzeichnet durch** die Schritte:

- Detektieren der abgegriffenen elektrischen Spannung ($U_{POTI\text{-}PIN1}\text{-}IA/IB$; $U_{POTI\text{-}PIN2}\text{-}IA/IB$) in einer ersten (POTI-PIN1-IA; POTI-PIN2-IA) der zumindest zwei Auswerteeinheiten über einen ersten Vorwiderstand (R867; R864);
- Bestimmen eines Werts der abgegriffenen elektrischen Spannung ($U_{POTI\text{-}PIN1\text{-}IA/IB}$; $U_{POTI\text{-}PIN2\text{-}IA/IB}$) in der ersten Auswerteeinheit (POTI-PIN1-IA; POTI-PIN2-IA);
- Detektieren der abgegriffenen elektrischen Spannung ($U_{POTI\text{-}PIN1\text{-}IA/IB}$; $U_{POTI\text{-}PIN2\text{-}IA/IB}$) in einer zweiten (POTI-PIN1-IB; PO-TI-PIN2-IB) der zumindest zwei Auswerteeinheiten über einen zweiten Vorwiderstand (R868; R865);
- Bestimmen eines Werts der abgegriffenen elektrischen Spannung ($U_{POTI\text{-}PIN1\text{-}IA/IB}$; $U_{POTI\text{-}PIN2\text{-}IA/IB}$) in der zweiten Auswerteeinheit (POTI-PIN1-IB; POTI-PIN2-IB);
- falls die in der ersten (POTI-PIN1-IA; POTI-PIN2-IA) und zweiten (POTI-PIN1-IB; POTI-PIN2-IB) Auswerteeinheit bestimmten Werte der abgegriffenen elektrischen Spannung ($U_{POTI\text{-}PIN1\text{-}IA}/IB$; $U_{POTI\text{-}PIN2\text{-}IA/IB}$) innerhalb vorgegebener Toleranzgrenzen nicht übereinstimmen, Bereitstellen von Daten, welche einer Fehlfunktion des Potentiometers (10) zugeordnet sind.

**6.** Verfahren nach einem der vorhergehenden Ansprüche,
**dadurch gekennzeichnet, dass**
an dem Potentiometer (10) ein Teilwiderstand ($X \times R860$) in den Grenzen 2% bis 98% des Gesamtwiderstands (R860) des Potentiometers (10) einstellbar ist und diese Grenzen durch eine mechanische Einstellung der Schleiferstellung begrenzt werden.

**7.** Vorrichtung zur Bestimmung einer Fehlfunktion eines Potentiometers (10), welche nach einem Verfahren gemäß einem der vorhergehenden Ansprüche arbeitet.

**8.** Steuereinheit mit einer Vorrichtung nach Anspruch 7, welche dazu ausgebildet ist, in einen festgelegten Betriebszustand überzugehen, wenn von der Vorrichtung Daten bereitgestellt werden, welche einer Fehlfunktion des Potentiometers (10) zugeordnet sind.

POTI-PIN2-IA — 1 [ ] 2 R864

POTI-PIN2-IB — 1 [ ] 2 R865

12

R863 1 [ ] 2 M

POTI-PIN1-IA — 1 [ ] 2 R867

POTI-PIN1-IB — 1 [ ] 2 R868

14

C822

R862 1 [ ] 2 M

M

10

2 R860 1 [ ] 3

POTI-PIN3-IA — 1 [ ] 2 R870

POTI-PIN3-IB — 1 [ ] 2 R871

16

U_v

R861 1 [ ] 2

C823

M

EP 2 511 719 A1

Europäisches
Patentamt

European
Patent Office

Office européen
des brevets

## EUROPÄISCHER RECHERCHENBERICHT

Nummer der Anmeldung

EP 11 16 2620

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 103 49 462 A1 (SIEMENS AG [DE]) 9. Juni 2005 (2005-06-09) * Absätze [0004] - [0010], [0018], [0019], [0023]; Abbildung 1 * ----- | 1-8 | INV. G01R31/02 |
| X | EP 1 494 098 A1 (SIEMENS AG [DE]) 5. Januar 2005 (2005-01-05) * Absätze [0005] - [0008], [0014], [0016], [0018], [0023]; Abbildung 1 * ----- | 1-8 | |
| A | US 6 181 141 B1 (JUNTUNEN ROBERT DEAN [US] ET AL) 30. Januar 2001 (2001-01-30) * Spalte 1, Zeile 47 - Spalte 2, Zeile 14; Abbildungen 1,2 * ----- | 1-8 | |
| A | US 2008/094080 A1 (DORWARTH RALF [DE] ET AL) 24. April 2008 (2008-04-24) * Absatz [0011] - Absatz [0012]; Abbildung 1 * ----- | 1-8 | |

RECHERCHIERTE SACHGEBIETE (IPC)

G01R

Der vorliegende Recherchenbericht wurde für alle Patentansprüche erstellt

| Recherchenort | Abschlußdatum der Recherche | Prüfer |
|---|---|---|
| München | 19. September 2011 | O'Callaghan, D |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...............................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 11 16 2620

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-09-2011

| Im Recherchenbericht angeführtes Patentdokument | Datum der Veröffentlichung | Mitglied(er) der Patentfamilie | Datum der Veröffentlichung |
|---|---|---|---|
| DE 10349462 A1 | 09-06-2005 | FR 2861465 A1 | 29-04-2005 |
| EP 1494098 A1 | 05-01-2005 | AT 327526 T | 15-06-2006 |
| US 6181141 B1 | 30-01-2001 | AU 1353100 A | 27-07-2000 |
| | | CA 2296939 A1 | 22-07-2000 |
| | | DE 60016984 D1 | 03-02-2005 |
| | | DE 60016984 T2 | 29-12-2005 |
| | | EP 1022570 A2 | 26-07-2000 |
| US 2008094080 A1 | 24-04-2008 | AT 517321 T | 15-08-2011 |
| | | AU 2006249125 A1 | 23-11-2006 |
| | | CA 2607879 A1 | 23-11-2006 |
| | | CN 101175975 A | 07-05-2008 |
| | | DE 102005023717 A1 | 23-11-2006 |
| | | EP 1882161 A1 | 30-01-2008 |
| | | WO 2006122767 A1 | 23-11-2006 |
| | | JP 2008541111 A | 20-11-2008 |
| | | NZ 563180 A | 30-07-2010 |

EPO FORM P0461

Für nähere Einzelheiten zu diesem Anhang : siehe Amtsblatt des Europäischen Patentamts, Nr.12/82